# EUROPEAN PATENT APPLICATION

(11) **EP 4 749 229 A1**
(43) Date of publication of application: **27.05.2026**
(21) Application number: 25214107.2
(22) Date of filing: 06.11.2025
(51) Int. Cl.: F28F 3/02, H10W 40/22

(54) **AN ADAPTIVE HEAT EXCHANGE PIN FOR A HEAT SINK, AND HEAT SINK HAVING SUCH AN ADAPTIVE HEAT EXCHANGE PIN**

(30) Priority: 21.11.2024 IT 202400026220
(71) Applicant: C.I.R.A. (Centro Italiano Ricerche Aerospaziali) - S.C.P.A., 81043 Capua (CE) (IT)
(72) Inventor: AMEDURI, Salvatore, 81043 Capua CE (IT); BRINDISI, Angela, 81043 Capua CE (IT); CONCILIO, Antonio, 81043 Capua CE (IT); DIMINO, Ignazio, 81043 Capua CE (IT); GALASSO, Bernardino, 81043 Capua CE (IT); MARINARO, Gianluca, 81043 Capua CE (IT); ROMANO, Diego Giuseppe, 81043 Capua CE (IT)
(74) Representative: Perani & Partners S.p.A.

(57) **Abstract**

The present invention concerns an exchange pin (2) for thermal management in electrical and/or electromechanical devices such as power converters, the adaptive pin (2) comprising a Shape Memory Alloy (SMA) core element (21) configured to change the geometry of the pin (2) in response to a temperature increase. The core element (21) has a first end portion, configured to be secured to a base (110) of a heat sink (100), and a second end portion. A pin cap (22) is secured to the second end portion of the core element (21). A metallic pin armor (23) has elongated sectors (231) connected to the pin cap (22) and surrounding the core element (21). The core element (21) is pre-loaded to shrink upon exceeding a threshold temperature, such as to pull the pin cap (22) toward the first end portion of the core element (21). Thus, the sectors (231) are compressed by the pin cap (22) and elastically bend away from the core element (21). Accordingly, heat exchange is increased, and the deformation reflects the temperature increase.

## Description

### Field of invention

The present application generally relates to thermal management systems, such as heat sinks, and more particularly to systems designed for optimizing heat exchange in electrical and/or electromechanical devices such as power converters using an adaptive heat exchange pin.

The project leading to this application has received funding from the European Union's Horizon 2020 research and innovation program under grant agreement No 101006771.

### Background of the invention

Nowadays the cooling of electric power converters is obtained mainly by using heat sinks allowing them to extract heat from the converters, transferring it to the external environment by convection.

Usually, heatsinks are made by a flat metallic plate with flat rectangular fins or pins with different section shapes (circular, triangular, rectangular etc.). Heat exchange of the coolant fluid can be increased by inserting a fan upstream of the heatsink. The pins or fins are usually arranged along streamwise and/or spanwise rows, with reference to the fluid stream direction.

### Problem of the prior art

Both heatsinks with and without fans can be subject to deposition of contaminating agents (for example dust) in the channels for coolant flow. If this contamination occurs, the partial obstructions of the channels can reduce the amount of heat dissipated by the heatsink, inducing an increase of the working temperature of the converter, worsening equipment performance.

Therefore, periodic maintenance is required to prevent the temperature of the converter from exceeding the design limits and the electronic components from burning.

### Summary of the invention

The invention addresses the problem of thermal management in electrical and electromechanical devices such as power converters, necessary to avoid for instance overheating and reduced efficiency.

In particular, the invention aims at enhancing heat exchange by modifying the geometry of thermal management pins in response to temperature fluctuations, thereby addressing the challenges associated with maintaining optimal operating conditions in electrical and electromechanical devices.

These objects are achieved by an adaptive thermally exchange pin for a heat sink, and by a heat sink and a heat sink system comprising the adaptive pin, according to any one of the appended claims.

The invention provides that the adaptive pin comprises an elongated core element made of a shape memory alloy. The core element has a first end portion, configured to be secured to a base of a heat sink. A pin cap is secured to a second end portion of the core element. A metallic pin armor comprises elongated sectors connected to the pin cap, the sectors extending along the core element and surrounding the core element.

The core element is pre-loaded to shrink upon exceeding a predetermined threshold temperature, such as to pull the pin cap toward the first end portion of the core element. Thus, the sectors are compressed by the pin cap and elastically bend away from the core element.

The deformation of the sectors causes an overall change in the shape of the pin, which causes the pin to dissipate more heat. Advantageously, by setting the threshold temperature of the core element below the maximum design temperature of a device attached to the heat sink, as the actual temperature approaches the maximum design temperature, the pins change their shape, increase heat exchange, and help to preserve the converter from reaching and exceeding the maximum design temperature.

Additionally, the first time the actual temperature exceeds the threshold temperature, the pins change their shape, and this can be easily noted. Thus, a human operator can easily understand that the thermal performance has deteriorated and the risk of reaching the maximum design temperature has increased. This can be taken as a warning that maintenance is required, with greater urgency the more the pins are deformed. Therefore, maintenance can be performed only when actually needed, without much risk of acting too late.

In advantageous embodiments, pin deformation is automatically monitored based on a change in resistivity of the core element, which is affected by the phase-change occurring at the threshold temperature.

### Brief description of the drawings

The present invention will now be described in more detail hereinafter with reference to the accompanying drawings, in which embodiments of the invention are shown.
Figures 1a-1b are perspective views of heat sinks according to two embodiments of the present invention,
Figure 2 is a top view of a detail of the heat sink of figure 1b,
Figure 3 is a perspective view of a detail of an adaptive pin for the heat sinks of FIGs 1a-1b, in a rest configuration,
Figure 4 is a bottom view of the pin of Figure 3,
Figure 5a is a front view of a detail of the pin of F Figure 3,
Figure 5b is a side section view of a detail of the pin of Figure 3, and
Figure 6 is a perspective view of the pin of Figure 3, in a shortened configuration.

### Detailed description

An object of the invention is an adaptive heat exchange pin 2 for a heat sink 100.

Another object of the invention is a heat sink 100 comprising a base panel 110 and a plurality of pins 120, wherein the plurality of pins 120 comprises a plurality of adaptive pins 2. The drawings schematically show an example shape of the panel 110 and arrangement of the pins 120, but many other shapes of the panel 110 (such as rounded or non-planar) and arrangements of the pins 120 can be selected by the skilled person.

The base panel 110 has a first face and an opposite second face. The first face is configured to contact a heat source, which is preferably an electrical or electromechanical device such as a power converter (not shown). Securing elements can be provided as known to the skilled person to fix the base panel 110 to the converter.

Instead, the pins 120 project from the second face of the base panel 110, namely in a direction opposite the converter.

Still another object of the invention is a heat sink system, comprising the heat sink 100 and some additional components complementing some functions of the heat sink 100.

The adaptive pin 2 comprises an elongated core element 21, such as a wire, made of a Shape Memory Alloy (SMA). The core element 21 may also consist of a bundle of plural wires.

The core element 21 has a first end portion, configured to be secured to the base panel 110 of the heat sink 100, and an opposite second end portion, spaced from the first end portion in a longitudinal direction X-X.

Preferably, the first end portion of the core element 21 is mechanically secured to the base panel 110. For example, the first end portion can be knotted to an element (not shown) projecting from the base panel 110, such as a bollard-shaped post element. In other embodiments, the first end portion can be fixed to the base 110 by a mechanical fastener such as a screw or a wedge or can be soldered to the base 110.

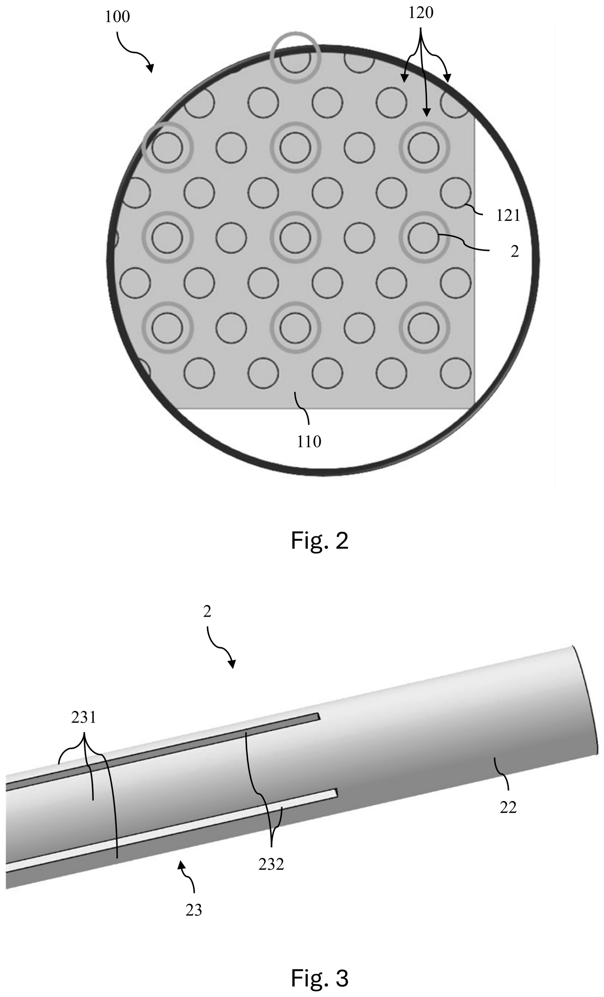

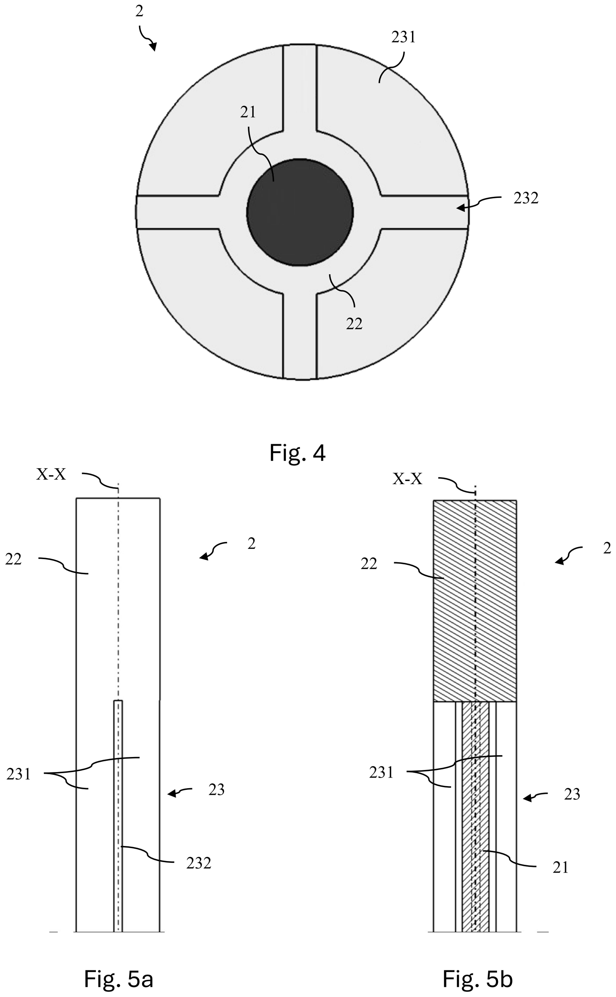

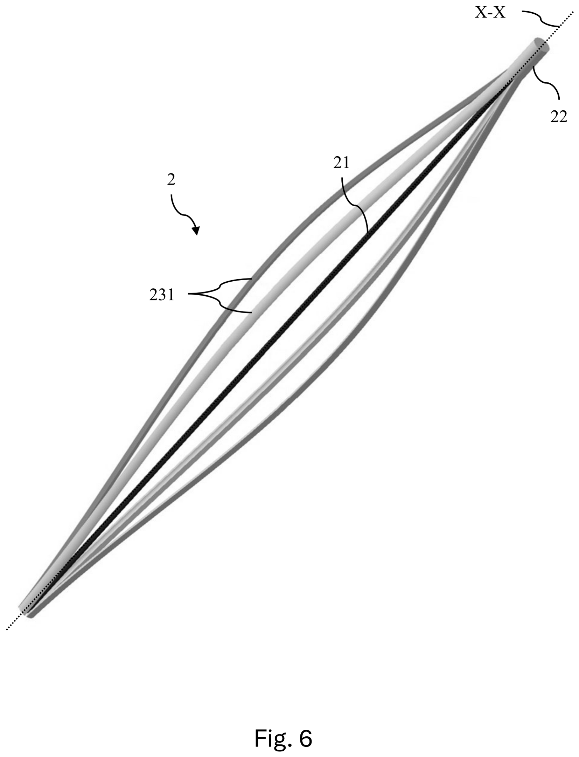

The core element 21 is pre-loaded to shrink upon exceeding a predetermined threshold temperature, passing from a rest configuration (figures 3-5b) to a shortened configuration (Figure 6). The length of the core element 21 in the longitudinal direction X-X is lower in the shortened configuration compared to the rest configuration. Thus, the core element 21 is configured to change the geometry of the adaptive pin 2 in response to a temperature increase.

In more detail, the core element 21 is pre-loaded to exhibit a martensitic phase below the threshold temperature and to transition to an austenitic phase upon exceeding the threshold temperature, thereby contracting the wire and deforming the adaptive pin 2. A skilled person in the field of shape memory alloys will easily understand how to manufacture the core element 21 in order to achieve these properties.

The pre-loading of the core element 21 to exhibit a martensitic phase at a lower temperature and transition to an austenitic phase at a higher temperature allows for precise control over the activation temperature, ensuring the pin deforms at the intended thermal threshold.

Preferably, the shape memory alloy is a Nichel-Titanium (NiTiNOL) alloy, but other Shape Memory Alloys can be used, by taking as reference parameters like overall cost, max expected deformation, and so on. In particular, using a NiTiNOL wire as the core element 21 provides a reliable and repeatable phase transformation due to its well-characterized temperature-dependent shape memory effect, ensuring consistent performance over the operational life of the adaptive pin 2.

The inherent corrosion resistance and biocompatibility of NiTiNOL make the adaptive pin 2 suitable for use in a wide range of environments, including those with stringent safety and durability requirements.

The contraction of the core element and subsequent deformation of the adaptive pin 2 at the specified temperature can be used to modulate the mechanical and thermal contact with adjacent components, optimizing heat transfer efficiency.

As detailed below, the adaptive pin 2 is deformable to increase the surface area available for heat exchange. This significantly enhances the convective heat transfer capabilities, allowing for more efficient cooling of the power converter. By increasing the surface area, the adaptive pin 2 can dissipate heat over a larger volume, reducing the thermal resistance and minimizing the risk of hot spots, which can lead to component failure.

The adaptive pin 2 comprises a pin cap 22 secured to the second end portion of the core element 21. Thus, upon the core element 21 shrinking, the pin cap 22 is pulled closer to the first end portion of the core element 21.

For example, the second end portion of the core element 21 may be secured to the pin cap 22 by a mechanical fastener, such as a screw (not shown) pressing the second end portion into a seat of the pin cap 22, or by knotting the second end portion around a post element (not shown) of the pin cap 22, like a bollard-shaped post element, or by soldering to the pin cap 22.

The operative connection between the SMA element and the cap 22 ensures a direct and efficient transmission of force, which can be utilized in applications requiring precise control of component positioning or secure locking mechanisms that respond to thermal triggers.

The adaptive pin 2 further comprises a pin armor 23 surrounding the core element 21. The pin armor 23 is the main heat exchange part, and so it is made of a highly dissipating material, namely conductive material (such as metallic materials like aluminum, copper, steel etc.).

Preferably, the pin cap 22 and the pin armor 23 are formed in one and the same piece. This improves thermal conduction from the base panel 110, through the core element 21, up to the pin cap 22 and pin armor 23.

In alternative embodiments, the pin cap 22 and the pin armor 23 are soldered to each other or mechanically secured to each other, for example by one or more fasteners such as screws (not shown).

The pin armor 23 comprises a plurality of elongated sectors 231 connected to the pin cap 22. Each sector 231 extends along the core element 21. In particular, each sector 231 has its own ends, spaced apart in the longitudinal direction X-X. A first end portion each sector 231 can be connected to the first end portion of the core element 21 and/or to the base 110 of the heat sink 100. In alternative embodiments, now shown, the first end portion of one or more sectors 231 can be free. A second end portion of each sector 231 is connected to the pin cap 22. Preferably, each sector 231 has substantially the same length as the core element 21, in the longitudinal direction X-X.

The pin armor 23 further comprises a plurality of slots 232. The sectors 231 of the pin armor 23 are separated from each other by the slots 232. The slots 232 are distributed in a circumferential direction around the core element 21.

Preferably, each slot 232 extends along the core element 21, between two ends spaced apart in the longitudinal direction X-X. The slots 232 are preferably at least three. Two slots 232 may cause some problems in the deformations described below.

Though rectilinear slots 232 and sectors 231 are shown in the drawings, other shapes could be suitable to obtain the advantages of the invention such as a helical shape.

The division of the pin armor 23 steel surface into sections along the pin axis facilitates targeted deformation, enabling a more uniform and controlled expansion of the surface area for heat exchange.

The segmented design of the steel surface allows for differential expansion of the adaptive pin 2, accommodating thermal expansion mismatches with other materials and reducing mechanical stresses during operation.

Sectors 231 are arranged and configured, when the first end portion of the core element 21 is secured to the base 110 and the core element 21 passes from the rest configuration to the shortened configuration, to be compressed by the pin cap 22 and elastically bend away from the core element 21. This results in the increased surface area for heat exchange.

In the embodiment shown in Figure 6 , when the slots 232 and sectors 231 are shaped in a rectilinear way, the sectors 231 bend such that a central portion of each sector 231 moves away from the core element 21, while end portions of the sector 231 remain close to the core element 21. This can be achieved for example by constraining the first end portions of the sectors 231 to the base 110, or to the first end portion of the core element 21.

However, in some other embodiments (not shown in the Figures), the first end portions of the sectors 231 are not directly connected neither to the base 110 nor to the core element 21. Instead, they may fit into a recess of the base 110, or they may abut a sloped portion of the base 110, shaped to make the first end portions of the sectors 231 converge toward the core element 21. Alternatively, the pin armor 23 may comprise a retaining ring, made in one piece with the sectors 231 (or soldered or fastened to the sectors 231) and joining the sectors 231 to each other at their first end portions. Still alternatively, a separate retaining ring may be arranged around the first end portions of the sectors 231 to retain them against the core element 21.

In all these embodiments, as the first end portion cannot significantly move away from the core element 21, when the core element 21 shrinks and the pin cap 22 is lowered, the sectors 231 are compressed between the pin cap 22 and the base 110, and their central portion naturally bend away from the core element 21, increasing the thermal exchange surface of the pin. In fact, after deformation, a cooling fluid such as air may circulate not only around the pin armor 23, but also in free spaces between the sectors 231 and the core element 21, whereby the core element 21 may contribute to the heat exchange.

In still other embodiments, the first end portions of the sectors 231 may be free to move away from the core element 21 upon compression of the sectors 231. In still other embodiments, the sectors 231 may be constrained not to move away from the core element 21 at other portions than the first end portions of the sectors 231, or in addition thereto, as long as some deformation to increase thermal exchange is allowed.

The ability of the pin cap 22 to compress the sectors 231 upon contraction of the SMA element allows for a self-adjusting mechanism that can maintain optimal contact pressure, enhancing the thermal conductivity and heat exchange capabilities of the system.

This configuration provides a passive means of regulating the surface area for heat exchange, which can be particularly beneficial in systems where active cooling is impractical or where minimal maintenance is desired.

In the heat sink 100 of the invention, the plurality of pins 120 may be all adaptive pins 2 as described above, but could comprise both adaptive pins 2 and traditional, non-adaptive pins 121. The non-adaptive pins 121 may be for example one-piece metal pins. In figure 2, adaptive pins 2 are circled, and non-adaptive pins 121 are not circled.

In a generic configuration, the adaptive pins 2 are spread among the non-adaptive pins 121, as schematically shown in figure 2, where the adaptive pins 2 have been circled. This reduces the risk that pin armors 23 of adjacent adaptive pins 2 contact each other during deformation, causing mechanical stress and significant deviation of the expected fluid flow. Thus, it is preferred that each adaptive pin 2 is adjacent to a plurality of non-adaptive pins 121, and not adjacent to any other adaptive pin 2.

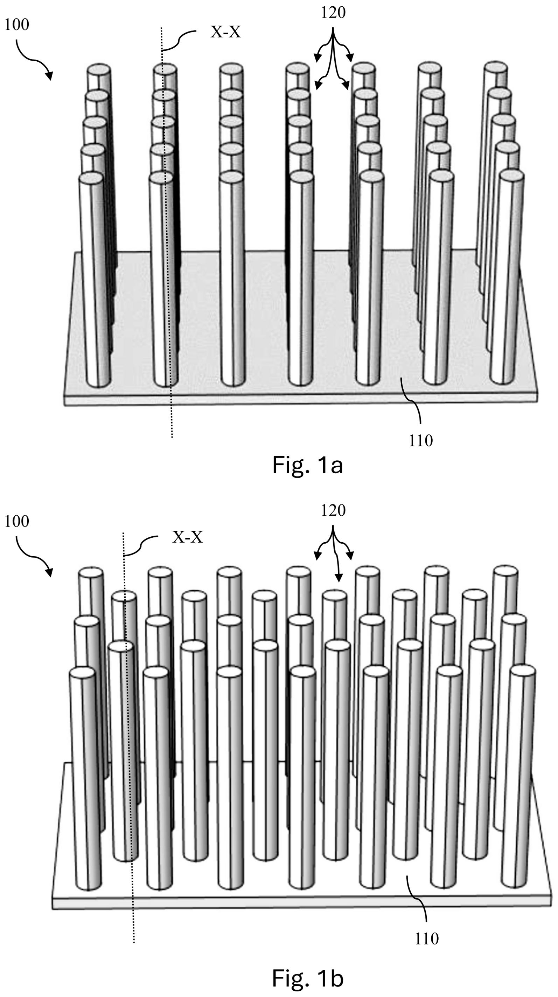

For example, the pins 120 may be arranged on the base 110 along transversal streamwise and spanwise rows. The rows may or may not be staggered to each other (as in figures 1b and 1a, respectively). Preferably, the pins 120 consecutive to each adaptive pin 2, both in its streamwise row and in its spanwise row, are non-adaptive pins 121.

The heat sink 100 system of the invention, in addition to the heat sink 100, comprises means for determining the temperature of the heat sink 100. Preferably, these are not means based on a direct temperature measure, but on an indirect measure linked to the deformation of the core elements 21.

In more detail, in an embodiment, a sensor (not shown) is configured to collect, from one or more adaptive pins 2 of the heat sink 100, a measured value of an electrical resistivity of the core element 21. In fact, in many shape memory alloys, the electrical resistance is indicative of the percentage of martensite present in the SMA element. The ability to measure electrical resistance as an indicator of the percentage of martensite present in the SMA element allows for precise control of the phase transformation, resulting in a quantitative measurement of the level of overheating beyond the threshold temperature.

The inclusion of means for measuring the electrical resistance of the SMA element offers a non-invasive method for monitoring the operational status and health of the adaptive pin 2, allowing for predictive maintenance and early detection of potential failures.

In other embodiments, a sensor might for instance be configured to collect, from one or more adaptive pins 2 of the heat sink 100, a measured value of a length of the core element 21 or the whole pin 2. This is another measure related to the amount of overheating beyond the threshold temperature.

A processor is in signal communication with the sensor (in both embodiments of the sensor), to receive the measured value and estimate a temperature of the heat sink 100, in particular an overheating temperature above the threshold temperature, as a function of the measured value.

By providing a quantitative measurement of the level of overheating, the system enables real-time feedback and control, which can be used to optimize performance and prevent damage to the pin or the broader system in which it is integrated.

In the described invention, advantageously the pin 2 is configured to operate without additional power sources or mechanical forces to activate the SMA element. The pin's configuration to operate autonomously without the need for additional power sources or mechanical forces to activate the SMA element simplifies the design and reduces the overall complexity of the system, leading to lower manufacturing and maintenance costs.

The self-sufficiency of the pin 2 in activating the SMA element enhances its suitability for use in remote or inaccessible locations, or in applications where reliability and independence from external power supplies are critical, such as in aerospace or military applications.

The dynamic change in geometry in response to temperature fluctuations allows for improved heat exchange during high-temperature operation, potentially extending the lifespan of the power converter components.

Moreover, the pin 2 provides the advantage of enhanced conductive properties, allowing for improved heat transfer in power converters. The pin 2 provides the advantage of amortized thermal management, effectively distributing thermal loads over time. The pin 2 provides the advantage of efficient heat exchange, ensuring that components remain within optimal temperature ranges. The pin 2 provides the advantage of attachable design features, facilitating easy integration into existing power converter systems. The pin 2 provides the advantage of solid structural integrity, ensuring durability and reliability under varying thermal conditions.

## Claims

1. An adaptive heat exchange pin for a heat sink (100), comprising:
- an elongated core element (21) made of a shape memory alloy, the core element (21) having a first end portion, configured to be secured to a base (110) of a heat sink (100), and a second end portion, said adaptive pin being **characterized by** comprising:
- a pin cap (22) secured to the second end portion of the core element (21), and
- a pin armor (23) surrounding the core element (21), the pin armor (23) comprising a plurality of elongated sectors (231) connected to the pin cap (22), each sector (231) extending along the core element (21),
- the core element (21) is pre-loaded to shrink upon exceeding a predetermined threshold temperature, passing from a rest configuration to a shortened configuration, such as to pull the pin cap (22) towards the first end portion of the core element (21),
- the sectors (231) are arranged and configured, when the first end portion of the core element (21) is secured to the base (110) and the core element (21) passes from the rest configuration to the shortened configuration, to be compressed by the pin cap (22) and elastically bend away from the core element (21).

2. The pin of claim 1, wherein each sector (231) of the pin armor (23) is configured, upon the core element (21) passing from the rest configuration to the shortened configuration, to bend such that a central portion of the sector (231) moves away from the core element (21), while end portions of the sector (231) remain close to the core element (21).

3. The pin of claim 1 or 2, wherein, each sector (231) of the pin armor (23) comprises a first end portion, which is configured to be connected to the first end portion of the core element (21) and/or to the base (110) of the heat sink (100), and a second end portion connected to the pin cap (22), preferably wherein each sector (231) has substantially the same length as the core element (21).

4. The pin of any claim 1 to 3, wherein the pin cap (22) and the pin armor (23) are formed in one and the same piece.

5. The pin of any claim 1 to 4, wherein the sectors (231) of the pin armor (23) are separated from each other by a plurality of slots (232) distributed around the core element (21), each slot extending along the core element (21), preferably at least three slots (232).

6. The pin of any claim 1 to 5, wherein the core element (21) is a wire of the Shape Memory Alloy, for example a Nichel-Titanium alloy, the pin armor (23) being a metallic element.

7. A heat sink (100) comprising:
- a base panel (110) having a first face configured to contact a heat source and a second face, the heat source being an electrical or electromechanical device, and
- a plurality of pins (120) projecting from the second face of the base panel (110),
**wherein** the plurality of pins (120) comprises a plurality of adaptive pins (2) according to any claim 1 to 6, each having the first end portion of the core element (21) secured to the base panel (110).

8. The heat sink (100) of claim 7, wherein the plurality of pins (120) further comprises a plurality of non-adaptive pins (121), the adaptive pins (2) being spread among the non-adaptive pins (121).

9. The heat sink (100) of claim 8, wherein each adaptive pin (2) is adjacent to a plurality of non-adaptive pins (121), and not adjacent to any other adaptive pin (2).

10. A heat sink system, comprising:
- the heat sink (100) of any claim from 7 to 9, and
- a sensor configured to collect, from one or more adaptive pins (2) of the heat sink (100), a measured value of an electrical resistivity of the core element (21), or a measured value of a length of the core element (21) or the whole adaptive pin (2), and
- a processor configured to estimate a temperature of the heat sink (100) as a function of said measured values.
